# EUROPEAN PATENT SPECIFICATION

(11) **EP 1 474 960 B1**
(45) Date of publication and mention of the grant of the patent: **18.01.2006**
(21) Application number: 03702500.4
(22) Date of filing: 22.01.2003
(51) Int. Cl.: H05K 3/00

(54) **DEVICE AND METHOD FOR TRANSPORTING FLAT WORKPIECES IN CONVEYORIZED PROCESSING LINES**
VORRICHTUNG UND VERFAHREN ZUM TRANSPORT VON FLACHEN WERKSTÜCKEN IN MIT FÖRDERBAND AUSGESTATTETEN BEARBEITUNGSSTRASSEN
DISPOSITIF ET PROCEDE SERVANT A TRANSPORTER DES PIECES PLATES SUR DES CHAINES DE TRAITEMENT MOBILES

(30) Priority: 12.02.2002 DE 10206660
(43) Date of publication of application: 10.11.2004
(73) Proprietor: ATOTECH Deutschland GmbH, 10553 Berlin (DE)
(72) Inventor: HÜBEL, Egon, 90537 Feucht (DE)
(74) Representative: Bressel, Burkhard
(86) International application number: PCT/EP2003/000622
(87) International publication number: WO 2003/069965

(56) References cited:
- EP-A- 0 913 348
- DE-A- 4 223 541
- DE-A- 19 835 332
- US-A- 3 793 867

## Description

The invention relates to a device for transporting flat workpieces in conveyorized lines. In a preferred application printed circuit boards and printed circuit foils are transported for processing in wet-chemical (horizontal or vertical) conveyorized processing lines.

In wet-chemical conveyorized lines workpieces, more specifically boards and foils, are preferably transported by motor-driven rollers. The term rollers is to be construed herein not only as cylindrical bodies, but also as any other rotationally symmetrical bodies that are capable of taking hold of and of transporting the boards and foils. Said rollers are substantially disposed at right angles to the direction of transport. The boards and foils are passed between upper and lower rollers. The rollers are driven by a drive gear or a belt drive. The upper rollers are carried in such a manner that the height at which they are positioned is automatically adjusted by the thickness of the boards and foils. The height at which the lower rollers are positioned is generally fixed. Accordingly, these lower stationary transport rollers determine the constant level of the underside of the printed circuit boards and foils. Usually, the axles of the rollers are only guided laterally. They may deflect in height though. The different heights at which the upper rollers for the printed circuit boards and foils, of from almost 0 mm to up to 10 mm thick, are positioned may be compensated for by the drive trains for the rollers.

In order to allow almost slip-free transportation of the boards by the rollers, the upper rollers at least must also have a certain minimum weight. In immersion baths, said weight must be such that the static buoyancy is more than compensated for. In baths with lower spray nozzles or flow nozzles the buoyancy force generated by the nozzle must be more than compensated for by the weight of the rollers or by additional means such as springs.

In addition to their transport function, the rollers perform still another function in immersion baths: the rollers cause the fluid used for processing (e.g. for immersion or spraying) to accumulate to such an extent that the workpiece may be conveyed through the corresponding processing bath in an immersed condition. At the entrance and at the exit thereof, said rollers perform the required sealing function. Said rollers are also termed sealing rollers. Lines of this type are described *i.a.* in DE 38 23 072 A1 and in DE 38 13 518 A1.

For electroplating board-shaped workpieces, rollers of various configurations are being used:

In US 3,348,657 A and DE 42 23 541 A1 for example there are described processing lines for etching printed circuit boards and for transporting printed circuit boards respectively. Various rotating transport means, such as coiled wires retaining and conveying the boards, are utilized for transporting printed circuit boards. In another embodiment, rollers with axially spaced apart wheels are utilized, several such rollers being paralleled. The rollers are disposed in such an arrangement relative to each other that the wheels of neighboring rollers are staggered. As a result thereof, the rollers may be held apart to such a small distance that the wheels of one roller are almost capable of contacting the axle of the neighboring roller.

DE 197 18 769 A1 further describes a device for processing and transporting printed circuit boards in which the transport rollers located within the processing zone have a specific design. The surface area of a transport roller has a prominence that extends in a helix configuration from one front side to the opposite front side.

EP 0 752 807 A1 discloses a device for the wet-chemical treatment of printed circuit boards and more specifically of the holes in printed circuit boards. The printed circuit boards are transported by rollers, some of said rollers additionally serving to deliver processing fluid to the surfaces of the boards and into the holes. The rollers suggested there may also be formed, *i*.*a*., by rings mounted on an axle.

The known devices and methods proved to be unsuitable in manufacturing printed circuit boards and printed circuit foils without generating scrap. Flaws repeatedly occur in the pattern, making a printed circuit board completely useless, more specifically as far as smallest structures of circuit traces are concerned.

It is therefore the object of the present invention to avoid the drawbacks of the prior art devices and methods and more specifically to find a device and a method of transporting flat workpieces in conveyorized lines that permit to avoid manufacturing-scrap.

The solution to this object is achieved by the device according to claim 1 and by the method according to claim 13. Preferred embodiments of the invention are recited in the subordinate claims.

The device and the method in accordance with the present invention serve to transport flat workpieces in conveyorized processing lines. Such type conveyorized processing lines preferably serve for wet-chemical treatment of printed circuit boards or printed circuit foils, *e.g.*, for etching and metal-plating as well as for all of the other processing techniques that are related to the previously mentioned processing methods such as pre-treatment, posttreatment, activation and deposition of protective layers. Conveyorized processing lines of this type are known. By way of example the reader is referred in this connection to the corresponding disclosure in DE 32 36 545 A1 and DE 36 24 481 C2. Typically, the transport devices in accordance with the invention are utilized in conveyorized processing lines in which the flat workpieces are conveyed horizontally. In this case, the workpieces are passed between two rollers of a pair of rollers or between those of several pairs of rollers, the rollers of a respective one of the pairs of rollers being arranged on top of each other and parallel to each other. The plane of transportation in which the workpieces are conveyed extends between the rollers of a pair of rollers. The useful area of the conveying path lies in the plane of transportation and is characterized by the area over which the workpiece is passed while it is being conveyed through the line. Conveying devices for processing fluid are usually disposed above and beneath the plane of transportation. Many different designs are conceivable for this purpose. For conducting electrolytic processes such as electrolytic etching or metal-plating processes, elements for contacting the workpieces are further provided through which current is supplied to the workpieces. Counter electrodes (anodes or cathodes) may also be disposed above and beneath the plane of transportation.

The device in accordance with the present invention comprises the following features:
a) at least one pair of rollers that are disposed on a respective side of the plane of transportation and are facing each other for transporting the workpieces, said rollers each having at least one elevation which more specifically annularly and/or helically encircles said rollers, and
b) transport drives associated with said rollers.

The workpieces are supplied to the rollers of the at least one pair of rollers in the plane of transportation, said rollers transporting and finally releasing them.

To achieve the object of the invention, the elevations are arranged in such a manner on the rollers opposing to each other that the elevations on the first roller of a pair located on one side of the plane of transportation is staggered relative to the elevations provided on the second roller of the pair on the other side of the plane of transportation.

It has been found out that the problems observed during the manufacturing of printed circuit boards are probably related to the fact that a buildup of dirt deposits on the transport rollers or sealing rollers which, on account of the weight of the rollers amounting to 5 kg for example, leaves impressions on the sensitive workpieces. If the roller has a circumference of 150 mm for example, a particle adhering to a roller leaves a disturbing impression on the surface of the workpiece after each conveying distance of 150 mm. Smallest impressions, pits or scratches, which are not yet visible during manufacturing, spoil the quality of the boards and may even be a cause of scrap.

The ever increasing miniaturization of the electronic components causes the to-be-processed structures on printed circuit boards to become ever smaller and, as a result thereof, more sensitive to damage. In the fine line printed circuit technique (HDI: High Density Interconnect), the widths of the structures and the spacings therebetween amount to approximately 0.05 mm. Even smallest impressions, pits or scratches of *e.g*., only 3 *µ*m deep, are a cause of scrap in the subsequent processes involved in the manufacturing of printed circuit boards. In such type lines there are a great number of rollers so that the risk of scrap is great. The resulting costs are not accepted.

Dirt that may deposit on the rollers is *inter alia* brought into the baths by the workpieces. Even with permanent filtration it is not possible to entirely exclude the sporadic formation of deposits.

In chemical (electroless) metal-plating baths there is furthermore the risk that metal deposits on all the parts and walls of the entire bath. As a result, the transport and sealing rollers, which are preferably made from plastic material, are also at risk. A first, very small metal particle which is pressed into the surface of the plastic roller, forms a germ that progressively grows to become a disturbing particle. In practical operation, small pieces of metal also deposit on the rollers, more specifically after a longer life of the bath. This phenomenon is called wild growth. Such coated rollers leave hardly visible impressions on the workpieces. These are however sufficient to cause scrap. Therefore, the rollers must be taken out and cleaned daily. A similar problem arises during pattern plating. In this case, the rollers roll over the resist. If the thin resist is for example damaged by metal particles formed on the rollers, metal deposits on the surface of the resist, probably because the damage causes the electric resistance to become very small there so that current is allowed to flow between the anode and the copper lamination located beneath the resist.

Thanks to this specific arrangement of the elevations on the rollers of a pair of rollers, or to the corresponding relative arrangement of the two rollers, it is made certain that the force exerted by the rollers onto the workpieces is reduced or limited. For this purpose, the flat workpieces, more specifically when they are very thin, *e.g*., when they have a thickness of 1 mm or less, are deformed so that they are slightly undulated (deformed) by the roller resting upon it.

In developing the transport device in accordance with the present invention and in order to find a solution to this object, the following aspects had to be taken into consideration:

In an effort to prevent dirt from leaving impressions, the invention aims at keeping the weight of the upper roller low. On the other side, it has to be taken into consideration that the transport function and the sealing function have to be preserved. It has for example been found out that, if the upper roller is too light, slip occurs during transport of the workpieces. It has further been found out that too light sealing rollers are not capable of retaining the fluid to a sufficient extent within the area of operation. In practical operation, and in order to meet these requirements, a minimum weight of 5 kg is required for a 700 mm long roller for example. It has been found out though that such a high weight already suffices to cause dirtied rollers to leave disturbing impressions in the surface of the workpieces.

One solution to this problem seemed to consist in using what are termed wheel shafts in wet-chemical processing lines. In this case, small, disc-shaped wheels are spaced e.g., 50 mm apart on a mostly driven shaft. When viewed radially, said wheels are about 5 mm long. On the upper and lower shafts, the wheels are normally disposed in such a manner that they roll exactly one upon the other. Such an arrangement is described in US 5,176,158 A for example. It is intended to allow transport of printed circuit foils for example. In order however to achieve transport function, the upper wheel shafts must exert a great enough force onto the lower wheel shafts. Meaning, there is the risk, in the region of the wheels, that particles depositing on the circumference of the wheels leave disturbing impressions on the foils. With the dimensions mentioned herein above, the probability of flaws is reduced to approximately 10 % because approximately 10 % only of the surface of the workpiece is brought into contact with the wheels. Transport of thicker, *i*.*e*., heavier printed circuit boards that are to be produced in the same wet-chemical line, is no longer guaranteed though. It is also particularly disadvantageous that the wheel shafts are not capable of performing the function of sealing immersion baths. They are therefore not a generally applicable solution.

In a preferred embodiment of the invention, several axially spaced apart elevations are provided on at least one roll of a pair of rolls. As a result, the pressure from the upper roller is very evenly transmitted to the workpieces so that the risk that particles leave an impression in the surface of the workpieces is reduced.

The elevations on the rollers may more specifically annularly or helically encircle the rollers. Other variants are of course conceivable such as helical portions with a small pitch alternating with free spaces in which there are no elevations. Further, helical elevations may have the same or a varying pitch over the entire length of the roller. Finally, the elevations may enclose the circumference of the roller either continuously or discontinuously. The condition in accordance with the purpose of the present invention for configuring the elevations is that, during rotation, the elevations of one roller of a pair of rollers engage corresponding spaces provided between the elevations of the other roller of the pair of rollers which rotates in the opposite direction.

Another improvement of the invention is that at least one bordering elevation may be provided on the ends of the rollers, more specifically outside that area of the conveying path which is useful for the workpieces, said elevation annularly encircling the respective one of the rollers. More specifically, these bordering elevations are arranged on the rollers of a pair of rollers so as to face each other. The area of the conveying path which is useful for the workpieces is formed by the area within the plane of transportation over which the workpieces are passed while they are being conveyed through the conveyorized processing line.

This improvement of the invention permits to prevent thin boards and foils e.g., printed circuit foils from being deformed too much. The diameter of the bordering elevations of opposing rollers may be dimensioned in such a manner that the deformation is minimized in that, at the slightest deflection, the bordering elevations come to rest upon each other either directly or at least through the border regions of the workpieces. If, in the border regions, dirt is impressed into the surface as a result of the increased pressure thus generated and exerted onto the surface of the workpieces, this does not constitute a problem since these dirtied surfaces are only to be found in the border region in which there usually is no conductive pattern. By contrast, the force exerted by the elevations onto the central region of the surfaces of the workpieces is relatively small since it only is the force applied by the staggered elevations on the rollers of a pair of rollers for deforming the workpieces.

The deformation of thin workpieces may be minimized even further in that the diameter of the bordering elevations is optimized relative to that of the central elevations on the rollers: if for example the bordering elevations are located far outside the useful area of the conveying path so that different sizes of workpieces may be processed in one line, the sum of the radii of the bordering elevations should possibly be greater than the sum of the radii of the central elevations on the rollers by the thickness of the workpieces. The result thereof is that the workpieces are hardly deformed any longer since the bordering elevations compensate for the thickness of the workpieces when it may be assumed that the dirt particles located between bordering elevations rolling directly on each other have the same size as those located between the central elevations on the rollers and the surface of the workpieces. On these conditions, the force exerted onto the surface of the workpieces is extremely small. On the other side, it must still be large enough to allow for secure transport of the workpieces. If it may be assumed, on the other side, that the bordering elevations roll on each other along the workpieces, in the region of the plating edge for example, the sum of the radii of the bordering elevations may be equal to the sum of the radii of the central elevations on the rollers since the workpieces are in this case largely prevented from deforming so that the force exerted onto the surface of the workpieces becomes very small - again provided that the particles on the bordering elevations and the particles on the central elevations on the rollers have approximately the same size.

In an advantageous embodiment of the present invention the spacings between the elevations annularly encircling the rollers or the spacings between respective turns of the elevations helically encircling the rollers are at least 10 % greater than the width of the elevations. Moreover, the height of the elevations may range from 0.1 mm to 10 mm, preferably from 0.1 mm to 1 mm. With this proviso, a slight difference in diameter between the regions provided with the elevations and the regions located therein between is made possible. Such a slight difference in diameter makes particular sense when the rollers for sealing against fluid flowing out of the processing line are to be utilized at the entrance or exit thereof. The gaps between the rollers and the workpieces resulting from the slight difference in diameter are very small so that the quantity of fluid flowing there through is minimized. Further, the width of the elevations as well as the spacings between the elevations annularly encircling the rollers and the spacings between respective turns of the elevations helically encircling the rollers may range from 2 mm to 200 mm. All of these further measures permit to optimize the deformation of the workpiece and, as a result thereof, the force exerted by the rollers onto the workpiece.

In a preferred embodiment of the invention the rollers are lengthened by at least the length of the bordering elevations at the ends of the rollers and are disposed in the processing line in such a manner that the bordering elevations at the ends of the rollers are located outside of the useful area of the conveying path occupied by the workpieces. Thanks to this measure, the force exerted by the weight of the respective one of the upper rollers of a pair of rollers onto the workpieces is limited. For, in that the bordering elevations are located outside of the useful area of the conveying path used by the workpieces, the bordering elevations of the two rollers of a pair of rollers are lying directly on top of each other and roll on each other so that the force is directly transmitted from the upper roller to the lower one without the workpieces being contacted in this region by the bordering elevations. As well particles are thus prevented from being pressed into the border surface of the workpieces in the border regions.

To further reduce topical application of pressure it is further proposed to round off the front sides of the elevations. As a result thereof, increased pressure is prevented from being exerted through edges of central elevations in the useful area of the conveying path onto the workpieces.

The rollers are preferably made from metal, plastic material or ceramics or from a combination of these materials. More specifically, the rollers may be plastic rollers provided with a metal core. In another embodiment the rollers may be hollow within the interior thereof.

In an advantageous embodiment, the rollers are configured with rings and/or helices mounted on axles in such a manner that they are reliably prevented from slipping and twisting. They are thus easy to manufacture. Said rings and helices may be pressed, screwed, clamped, bonded or welded thereon. If very small differences in diameter between the regions on a roller in which the elevations are located and the regions located therein between are desired, the manufacturing of such rollers may be complicated since very thin elevations may be formed on the rollers (thickness, as indicated herein above, of from 0.1 mm to 1 mm). In this case, it may be advantageous to produce elevations by pressing, screwing, clamping, bonding or welding for example component parts onto an axle, said elevations consisting of rings and of other elements that have a diameter slightly smaller than that of the rings. The elevations and the regions located therein between may for example be formed by pushing and fixing component parts with a border forming the elevation and with an integrally molded groove in the form of a tube portion of a smaller diameter. In this case, the elevations and the grooves located therein between are formed by pushing these identically oriented parts thereon so that the rings and the tube portions forming the grooves are alternated.

In another embodiment of the invention, the minimum spacing between the rollers of a pair of rollers is set by the spacing between the respective bearings to be such that the workpieces are not deformed beyond the size of the particles adhering to the rollers.

The invention is described herein after in close detail with reference to the Figs. 1 -4:
- **Fig. 1**: is a not-to-scale sectional view of a pair of rollers for use in the device according to the invention viewed in the direction of transport;
- **Fig. 2**: is a to-scale detail of a pair of rollers; a to-be-processed thin printed circuit board is located between the upper and the lower rollers;
- **Fig. 3**: is a to-scale detail of an embodiment of the device in accordance with the invention for use as a sealing roller in a printed circuit board line;
- **Fig. 4**: is a sectional view of a pair of rollers viewed in the direction of transport and formed from component parts disposed on an axle in a conveyorized processing line, said component parts being comprised of ring and groove.

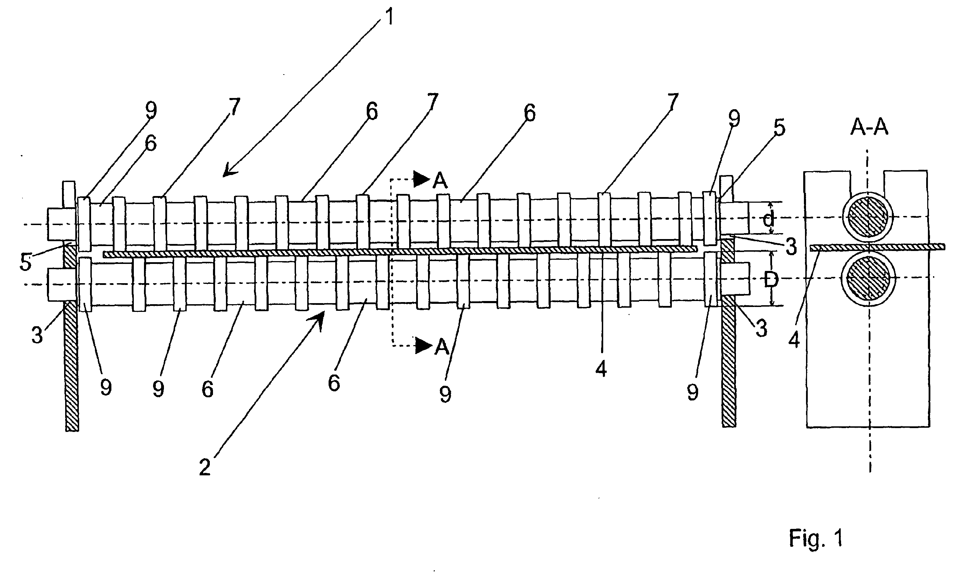

**Fig. 1** shows a pair of rollers in a conveyorized line of which a detail only is illustrated, said pair of rollers being comprised of an upper roller **1** and of a lower roller **2.** The lower roller **2** is carried in stationary lower bearings **3.** It thus determines the height at which the workpiece **4** is positioned.

The upper roller **1** is freely carried in such a manner that it is capable of automatically adjusting to the thickness of the workpiece **4.** The thrust bearings **5** serve this purpose. The rollers **1, 2** have annular grooves **6** and elevations **7** disposed therein between and configured as rings in the present case. The upper roller **1** and the lower roller **2** of the pair of rollers are designed and carried in such a manner that regions of the one roller **1** with a large diameter **D'** are facing regions of the other roller **2** with a small diameter **d** and vice versa. In the axial direction, the spaces **6** between the elevations **7** with small diameter **d** are longer than the elevations **7** with larger diameter **D'.** On the one side, shear stress is thus prevented from occurring between the upper and lower rings **7** and on the other side, the printed circuit boards and printed circuit foils **4** are given more space for elastic deflection.

Usually, the two rollers **1** and **2** are driven by a roller drive train that has not been illustrated herein. Said drive train determines the transport speed that corresponds to the circumferential speed of the rings **7** with the large diameter **D'.**

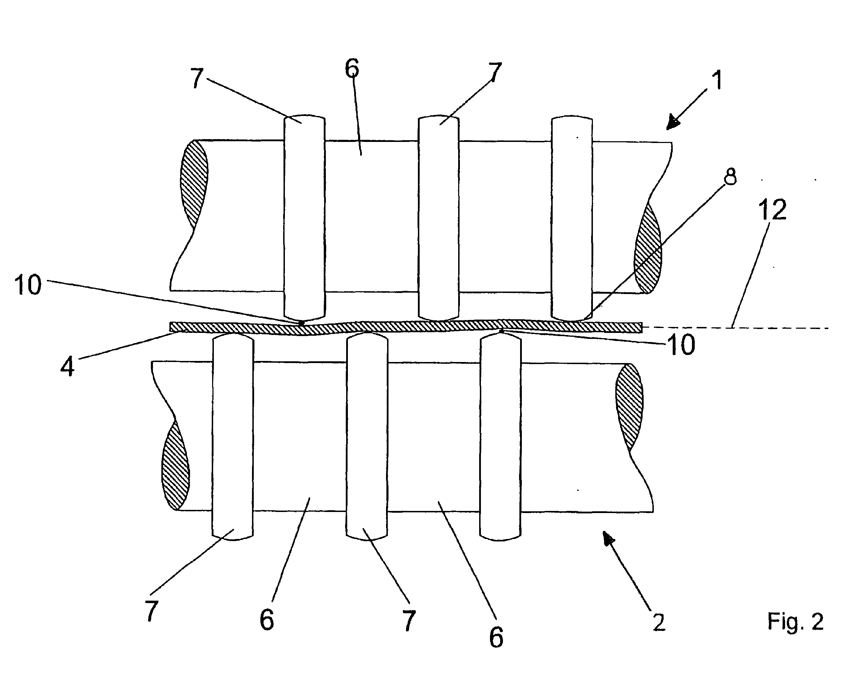

In a preferred embodiment of the invention the ends of the rollers **1** and **2** are not grooved. The bordering elevations **9** of the upper roller **1** and of the lower roller **2** are rolling on each other at the ends thereof when no printed circuit board is placed between the rollers **1, 2.** As a result, very thin foils **4,** *e.g*., foils 4 of 50 *µ*m thick, are prevented from being deformed too much. In this case, the foils **4** deform slightly so that the bordering elevations **9** roll directly upon each other. As a result, the force that causes the foils **4** to deform is limited. **Fig. 2** shows in greater detail that a printed circuit foil **4** is slightly deformed by the weight of the upper roller **1.** The elevations **7** of the upper roller **1** press the foil **4** into the spaces **6** between the elevations **7** of the lower roller **2;** concurrently, the elevations **7** of the lower roller **2** press into the spaces **6** between the elevations **7** of the upper roller **1:** In this case, the rings **7** are allowed to press the foil **4** into the opposing groove **6** only until the bordering elevations (bordering rings) **9** at the ends of the rollers roll upon each other (not shown). Said deformation substantially corresponds to the size of the particles **10** adhering to the elevations **7.** The end region of the rollers **1, 2** preferably lies in a region located outside of the useful area of the conveying path (the useful area of the conveying path is given by the width of the printed circuit board **4** (see **Fig. 1**)). The forward drive needed for the printed circuit boards and printed circuit foils **4** takes place in the center of the transport. In the case of larger sized printed circuit boards and printed circuit foils **4,** the border region thereof may also extend into the end region of the rollers **1, 2.** The useful area of the printed circuit boards and foils **4** is not affected thereby because the outer borders thereof are not used for patterning (plating edge).

In order to prevent too strong a deformation of the printed circuit foils **4,** the minimum spacing between the rollers **1, 2** may be adjusted - as described - either by the bordering elevations **9** rolling on each other, or through the position of the upper bearings **5** relative to the lower bearings **3.** The greater the distance between the upper bearing **5** and the lower bearing **3,** the greater the safe distance.

To illustrate the problem the present invention is directed to resolve, **Fig. 2** shows disturbing particles **10** on the front sides **8** of the elevations **7.** As the printed circuit boards or foils **4** are allowed to evade into the space **6,** the particles **10** are not pressed into the surface of the workpieces **4.** As a result, the printed circuit board or foil **4** remains undamaged even if in practical operation the weight of the upper roller **1** amounts to 5 to 10 kg in order to guarantee secure transport of the workpieces **4.**

**Fig. 2** is a many times magnified to-scale detail of an upper roller **1** and of a lower roller **2.** This Fig. also illustrates that a pair of rollers may also perform the function of sealing a dammed up wet-chemical bath when the spaces **6** between the elevations **7** have a small width, as shown herein. The height of the fluid accumulated in the operation region in the conveyorized line usually amounts to 50 mm maximum. Therefore, the loss of fluid escaping through the remaining openings, of *e.g*., less than 0.5 mm, of a pair of rollers is negligibly small.

To prevent longitudinal traces from forming on the printed circuit boards and printed circuit foils **4,** the rings **7** have rounded front sides **8.** The rings **7** may also be rounded over the entire front side thereof in order not to leave an impression on the edges of the printed circuit boards and foils **4** if the boards or foils **4** risk to become too undulated.

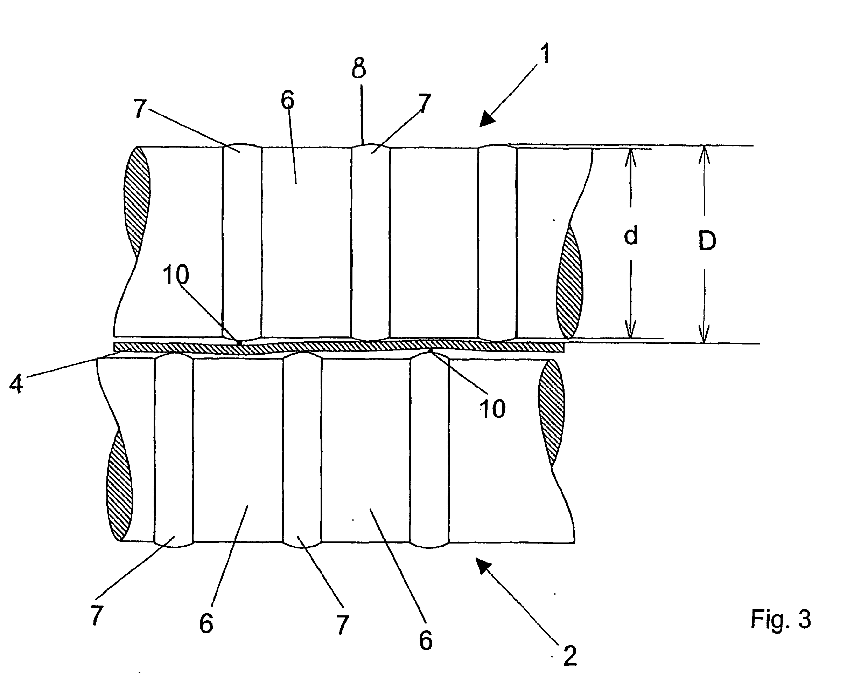

Herein after an example taken from the printed circuit board technique is given (in this connection refer to **Fig. 3):**

In horizontal conveyorized lines the length of the rollers **1, 2** typically amounts to 700 mm. A space **6** is formed between two rings **7.** In the axial direction, the length of the space **6** amounts for example to 25 mm. The ring **7** has for example a length of 15 mm. The bordering rings **9** at the ends of the rollers **1, 2** also have a length of for example 15 mm (not shown). The diameter **D'** of the rings **7** amounts for example to 50 mm and the diameter d of the spaces **6** between the rings **7** to 49.5 mm. In this case as well the rings **7** have rounded front sides **8.**

The rollers **1, 2** are made for example from plastic material, metal or ceramics or from a combination of these materials. Plastic rollers may be provided with a metallic core in an effort to increase the weight and to thus increase safety of transport. However, the invention is not limited to the dimensions mentioned above which have been given by way of example only. The difference in diameter between the spaces **6** between the rings **7** and the rings **7** may range from 0.1 mm to 10 mm, preferably from 0.1 mm to 1 mm. The axial length of the **rings 7** may range from 2 mm to 200 mm.

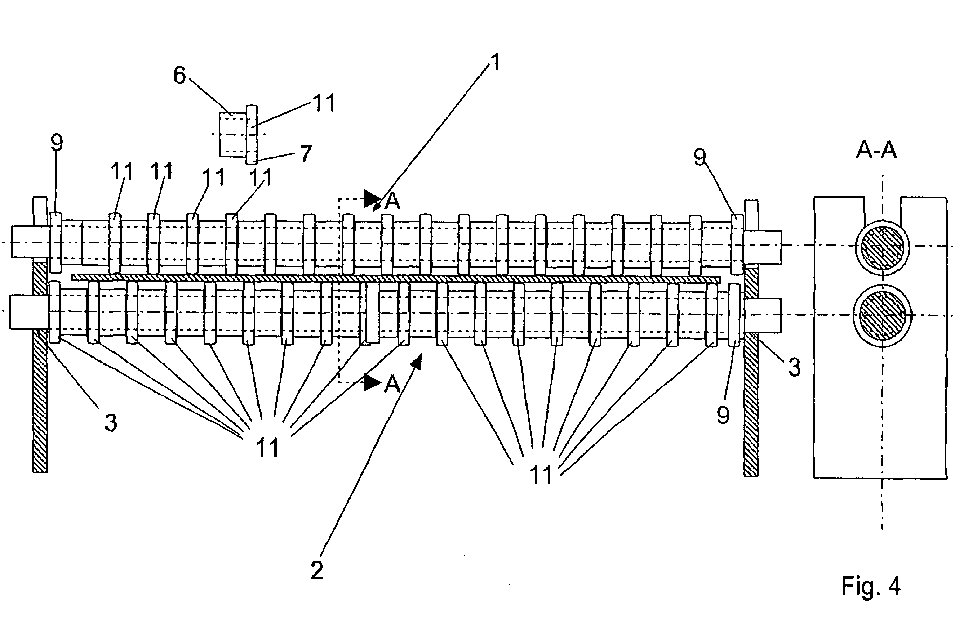

The rollers **1, 2** in accordance with the invention may be comprised of several component parts (in this connection, refer to **Fig. 4).** In order to manufacture the contoured rollers **1, 2** in accordance with the purpose of the present invention with elevations (rings ) **7** and spaces **6** between said rings **7,** appropriate component parts **11** may be pressed, screwed, clamped, bonded or welded to the diameter or profile of the axle of the rollers **1, 2** to form the rings **7** and the spaces **6** between the rings **7.** A component part **11** of this type is shown separately in **Fig. 4.** If the component parts **11** are clamped onto the rollers **1**, **2**, a profile with three or multiple edges that reliably prevents the components parts **11** from slipping through may be used for the axle. If, by contrast, the rollers **1, 2** are not to perform a sealing function, the spaces **6** between the rings **7** may be quite deep and the axles of the rollers **1, 2** quite thin so that the transfer of material at these locations is less hindered. All publications, patents and patent applications cited herein are hereby incorporated by reference.

### Listing of Numerals:

- **1**: upper roller
- **2**: lower roller
- **3**: stationary bearing
- **4**: workpiece (printed circuit board, printed circuit foil)
- **5**: thrust bearing
- **6**: space between two elevations (rings) **7** (groove)
- **7**: elevation (ring)
- **8**: rounded front side of an elevation **7**
- **9**: bordering elevation (bordering ring) at the end of the roller **1, 2**
- **10**: particle (dirt)
- **11**: component part for forming an elevation (ring) with integrally molded space (groove)
- **12**: plane of transportation
- **D**: diameter of the roller including the bordering elevations **9**
- **D'**: diameter of the roller including the elevations **7**
- **d**: diameter of the roller without taking into consideration the elevations **7** and the bordering elevations **9**

## Claims

1. A device for transporting flat workpieces in conveyorized processing lines with a plane of transportation for the workpieces, said device comprising the following features:
a) at least one pair of rollers that are disposed on a respective side of the plane of transportation and are facing each other for transporting the workpieces, said rollers each having at least one elevation encircling said rollers, and
b) transport drives associated with said rollers,
wherein the elevations (**7**) on the first roller (**1**) of a pair of rollers located on one side of the plane of transportation (**12**) is staggered relative to the elevations (**7**) provided on the second roller (**2**) of the pair of rollers on the other side of the plane of transportation (**12**).

2. The device according to claim 1, wherein the elevations (**7**) annularly or helically encircle the rollers (**1, 2**).

3. The device according to one of the preceding claims, wherein several axially spaced apart elevations (**7**) are provided on the at least one roller (**1, 2**).

4. The device according to one of the preceding claims, **wherein** there is provided at least one bordering elevation **(9)** at the end of the rollers **(1, 2),** said bordering elevation annularly encircling the respective one of the rollers (**1**, **2**) and wherein said bordering elevations **(9)** are disposed on the rollers **(1, 2)** of a pair of rollers so as to face each other.

5. The device according to one of the preceding claims, **wherein** the minimum spacing between the rollers **(1, 2)** of a pair of rollers is set by the spacing between the bearings **(3, 5)** of the rollers **(1, 2)** to be such that the workpieces **(4)** are not deformed beyond the size of the particles **(10)** adhering to the rollers **(1, 2).**

6. The device according to one of the preceding claims, **wherein** the spacings between the elevations **(7)** annularly encircling the rollers **(1, 2)** or the spacings between respective turns of the elevations **(7)** helically encircling the rollers **(1, 2)** are at least 10 % greater than the width of the elevations **(7).**

7. The device according to one of the preceding claims, **wherein** the height of the elevations **(7)** ranges from 0.1 mm to 10 mm.

8. The device according to one of the preceding claims, **wherein** the width of the elevations **(7)** as well as the spacings between the elevations **(7)** annularly encircling the rollers **(1, 2)** and the spacings between respective turns of the elevations **(7)** helically encircling the rollers **(1, 2)** may range from 2 mm to 200 mm.

9. The device according to one of the preceding claims, **wherein** the rollers **(1, 2)** are lengthened by at least the length of the bordering elevations **(9)** at the ends of the rollers **(1, 2)** and are disposed in a processing line in such a manner that the bordering elevations **(9)** at the ends of the rollers **(1, 2)** are located outside of a useful area of a conveying path in the processing line occupied by the workpieces **(4).**

10. The device according to one of the preceding claims, wherein the elevations **(7)** have rounded front sides **(8).**

11. The device according to one of the preceding claims, wherein the rollers **(1, 2)** are made from at least one material selected from the group comprising metal, plastic material and ceramics.

12. The device according to one of the preceding claims, wherein the rollers **(1, 2)** provided with the elevations **(7)** are configured to be formed by axles with rings secured thereon in such a manner that the rings are reliably prevented from slipping and twisting.

13. A method of transporting flat workpieces **(4)** in conveyorized processing lines with a plane of transportation for the workpieces **(4)** and with at least one pair of rollers **(1, 2),** said rollers facing each other and being disposed on a respective side of the plane of transportation for transporting the workpieces **(4),** the rollers **(1, 2)** having each at least one elevation **(7)** encircling the rollers **(1, 2),** the elevations **(7)** on the first roller **(1)** of a pair of rollers located on one side of the plane of transportation being staggered relative to the elevations **(7)** on the second roller **(2)** of the pair of rollers on the other side of the plane of transportation, and with transport drives associated with the rollers **(1, 2),**
the workpieces **(4)** being supplied to the rollers **(1, 2)** of the at least one pair of rollers in the plane of transportation, said rollers **(1, 2)** transporting and finally releasing them.

## Patentansprüche

1. Vorrichtung zum Transport von flachem Behandlungsgut in Durchlaufanlagen mit einer Transportebene für das Behandlungsgut, wobei die Vorrichtung folgende Merkmale aufweist:
a) mindestens ein Paar einander gegenüberliegender, an jeweils einer Seite der Transportebene angeordneter Walzen zum Transport des Behandlungsgutes, wobei die Walzen jeweils mindestens eine Aufwölbung aufweisen, die die Walzen umfasst, sowie
b) den Walzen zugeordnete Transportantriebe,
**dadurch gekennzeichnet, dass** die Aufwölbungen **(7)** an der ersten Walze **(1)** eines Walzenpaares an einer Seite der Transportebene (**12**) gegenüber den Aufwölbungen **(7)** an der zweiten Walze **(2)** des Walzenpaares an der anderen Seite der Transportebene **(12)** versetzt sind.

2. Vorrichtung nach Anspruch 1, **dadurch gekennzeichnet, dass** die Aufwölbungen **(7)** die Walzen **(1, 2)** ring- oder schraubenförmig umfassen.

3. Vorrichtung nach einem der vorstehenden Ansprüche, **dadurch gekennzeichnet, dass** an der mindestens einen Walze **(1, 2)** mehrere in axialer Richtung beabstandete Aufwölbungen (**7**) vorgesehen sind.

4. Vorrichtung nach einem der vorstehenden Ansprüche, **dadurch gekennzeichnet, dass** an den Enden der Walzen **(1, 2)** mindestens eine Randaufwölbung **(9)** vorgesehen ist, wobei diese Randaufwölbung die jeweilige Walze **(1, 2)** ringförmig umfasst, und dass die Randaufwölbungen **(9)** an den Walzen **(1, 2)** eines Walzenpaares einander gegenüberliegend angeordnet sind.

5. Vorrichtung nach einem der vorstehenden Ansprüche, **dadurch gekennzeichnet, dass** der Mindestabstand der Walzen **(1, 2)** eines Walzenpaares durch den Abstand zwischen den Lagern **(3, 5)** der Walzen **(1, 2)** so groß eingestellt ist, dass das Behandlungsgut **(4)** nicht über die Größe von an den Walzen **(1, 2)** anhaftenden Partikeln **(10)** hinaus verformt wird.

6. Vorrichtung nach einem der vorstehenden Ansprüche, **dadurch gekennzeichnet, dass** der Abstand der die Walzen **(1, 2)** ringförmig umfassenden Aufwölbungen **(7)** oder der Windungsabstand der die Walzen **(1, 2)** schraubenförmig umfassenden Aufwölbungen **(7)** um mindestens 10 % größer ist als die Breite der Aufwölbungen **(7).**

7. Vorrichtung nach einem der vorstehenden Ansprüche, **dadurch gekennzeichnet, dass** die Aufwölbungen **(7)** eine Höhe im Bereich von 0,1 mm bis 10 mm haben.

8. Vorrichtung nach einem der vorstehenden Ansprüche, **dadurch gekennzeichnet, dass** die Breite der Aufwölbungen **(7)** sowie die Abstände zwischen den die Walzen **(1, 2)** ringförmig umfassenden Aufwölbungen **(7)** und die Windungsabstände der die Walzen **(1, 2)** schraubenförmig umfassenden Aufwölbungen (**7**) im Bereich von 2 mm bis 200 mm liegen können.

9. Vorrichtung nach einem der vorstehenden Ansprüche, **dadurch gekennzeichnet, dass** die Walzen **(1, 2)** mindestens um die Länge der Randaufwölbungen (**9**) an den Enden der Walzen (**1**, **2**) verlängert und so in einer Behandlungsanlage angeordnet sind, dass sich die Randaufwölbungen **(9)** an den Enden der Walzen **(1, 2)** außerhalb einer vom Behandlungsgut **(4)** belegten Nutzflächentransportbahn in der Behandlungsanlage befinden.

10. Vorrichtung nach einem der vorstehenden Ansprüche, **dadurch gekennzeichnet, dass** die Aufwölbungen **(7)** abgerundete Stirnseiten **(8)** aufweisen.

11. Vorrichtung nach einem der vorstehenden Ansprüche, **dadurch gekennzeichnet, dass** die Walzen **(1, 2)** aus mindestens einem Material bestehen, ausgewählt aus der Gruppe umfassend Metall, Kunststoff und Keramik.

12. Vorrichtung nach einem der vorstehenden Ansprüche, **dadurch gekennzeichnet, dass** die die Aufwölbungen **(7)** aufweisenden Walzen **(1, 2)** durch Achsen mit darauf rutsch- und verdrehgesichert befestigten Ringen gebildet sind.

13. Verfahren zum Transport von flachem Behandlungsgut **(4)** in Durchlaufanlagen mit einer Transportebene für das Behandlungsgut **(4)** und mit mindestens einem Paar einander gegenüberliegender, an jeweils einer Seite der Transportebene angeordneter Walzen **(1, 2)** zum Transport des Behandlungsgutes **(4),** wobei die Walzen **(1, 2)** jeweils mindestens eine Aufwölbung **(7)** aufweisen, die die Walzen **(1, 2)** umfasst, und wobei die Aufwölbungen **(7)** an der ersten Walze **(1)** eines Walzenpaares an einer Seite der Transportebene gegenüber den Aufwölbungen **(7)** an der zweiten Walze **(2)** des Walzenpaares an der anderen Seite der Transportebene versetzt sind, sowie mit den Walzen **(1, 2)** zugeordneten Transportantrieben,
bei dem das Behandlungsgut **(4)** den Walzen **(1, 2)** des mindestens einen Walzenpaares in der Transportebene zugeführt, von diesen Walzen **(1, 2)** transportiert und schließlich wieder freigegeben wird.

## Revendications

1. Dispositif destiné à transporter des pièces plates à usiner sur des chaînes de traitement en continue avec un plan de transport pour les pièces, ledit dispositif comprenant les caractéristiques suivantes :
a) au moins une paire de rouleaux qui sont disposés sur un côté respectif du plan de transport et se font face destinés à transporter les pièces, lesdits rouleaux ayant chacun au moins une élévation encerclant lesdits rouleaux, et
b) des commandes de transport associées auxdits rouleaux,
dans lequel les élévations (7) sur le premier rouleau (1) d'une paire de rouleaux situés sur un côté du plan de transport (12) sont décalées par rapport aux élévations (7) prévues sur le second rouleau (2) de la paire de rouleaux sur l'autre côté du plan de transport (12).

2. Dispositif selon la revendication 1, dans lequel les élévations (7) encerclent les rouleaux (1, 2) en anneau ou en hélice.

3. Dispositif selon l'une des revendications précédentes, dans lequel plusieurs élévations espacées axialement (7) sont prévues sur au moins un rouleau (1, 2).

4. Dispositif selon l'une des revendications précédentes, dans lequel est prévue au moins une élévation en bordure (9) à l'extrémité des rouleaux (1, 2), ladite élévation en bordure encerclant l'un respectif des anneaux (1, 2) en anneau et dans lequel lesdites élévations en bordure (9) sont disposées sur les rouleaux (1, 2) d'une paire de rouleaux de façon à se faire face.

5. Dispositif selon l'une des revendications précédentes, dans lequel l'espacement minimum entre les rouleaux (1, 2) d'une paire de rouleaux est établi par l'espacement entre les paliers (3, 5) des rouleaux (1, 2) de façon à ce qu'il soit tel que les pièces (4) ne soient pas déformées au-delà de la taille des particules (10) adhérant aux rouleaux (1, 2).

6. Dispositif selon l'une des revendications précédentes, dans lequel les espacements entre les élévations (7) encerclant les rouleaux (1, 2) en anneau ou les espacements entre des tours respectifs des élévations (7) encerclant les rouleaux (1, 2) en hélice sont au moins de 10 % supérieurs à la largeur des élévations (7).

7. Dispositif selon l'une des revendications précédentes, dans lequel la hauteur des élévations (7) va de 0,1 mm à 10 mm.

8. Dispositif selon l'une des revendications précédentes, dans lequel la largeur des élévations (7) ainsi que les espacements entre les élévations (7) encerclant les rouleaux (1, 2) en anneau ou les espacements entre des tours respectifs des élévations (7) encerclant les rouleaux (1, 2) en hélice peuvent aller de 2 mm à 200 mm.

9. Dispositif selon l'une des revendications précédentes, dans lequel les rouleaux (1, 2) sont rallongés par au moins la longueur des élévations en bordure (9) à l'extrémité des rouleaux (1, 2) et sont disposés sur une chaîne de traitement d'une manière telle que les élévations en bordure (9) à l'extrémité des rouleaux (1, 2) sont situées à l'extérieur d'une zone utile d'une voie de convoyage dans la chaîne de traitement occupée par les pièces à usiner (4).

10. Dispositif selon l'une des revendications précédentes, dans lequel les élévations (7) ont des côtés avant arrondis (8).

11. Dispositif selon l'une des revendications précédentes, dans lequel les rouleaux (1, 2) sont faits à partir d'au moins un matériau sélectionné parmi le groupe comprenant le métal, les matériaux plastiques et les céramiques.

12. Dispositif selon l'une des revendications précédentes, dans lequel les rouleaux (1, 2) munis des élévations (7) sont configurés de façon à être formés par des axes ayant des anneaux fixés sur eux d'une manière telle que les anneaux soient empêchés d'une manière fiable de glisser et de se tordre.

13. Procédé de transport de pièces plates à usiner (4) sur des chaînes de traitement en continue avec un plan de transport pour les pièces (4) et avec au moins une paire de rouleaux (1, 2), lesdits rouleaux se faisant face et étant disposés sur un côté respectif du plan de transport destiné à transporter les pièces (4), les rouleaux (1, 2) ayant chacun au moins une élévation (7) encerclant les rouleaux (1, 2), les élévations (7) sur le premier rouleau (1) d'une paire de rouleaux situés sur un côté du plan de transport étant décalées par rapport aux élévations (7) sur le second rouleau (2) de la paire de rouleaux sur l'autre côté du plan de transport, et avec des commandes de transport associées aux rouleaux (1, 2),
les pièces (4) étant fournies aux rouleaux (1, 2) de la au moins une paire de rouleaux dans le plan de transport, lesdits rouleaux (1, 2) les transportant et enfin les relâchant.
